# EUROPEAN PATENT SPECIFICATION

(11) **EP 2 458 727 B1**
(45) Date of publication and mention of the grant of the patent: **09.01.2019**
(21) Application number: 11191282.0
(22) Date of filing: 30.11.2011
(51) Int. Cl.: H02M 7/5387, H02M 3/335, H02M 1/08, H02M 1/084

(54) **Gate driving power supply system and inverter control circuit**
Stromversorgungssystem für den Gate-Antrieb und Wandlersteuerschaltung
Système d'alimentation de commande de porte et circuit de contrôle d'inverseur

(30) Priority: 30.11.2010 JP 2010266874
(43) Date of publication of application: 30.05.2012
(73) Proprietor: Fuji Electric Co., Ltd., Kawasaki-shi 210-9530 (JP)
(72) Inventor: Amano, Isao, Kawasaki-shi, 210-9530 (JP); Terasawa, Noriho, Kawasaki-shi, 210-9530 (JP)
(74) Representative: MERH-IP Matias Erny Reichl Hoffmann Patentanwälte PartG mbB

(56) References cited:
- EP-A1- 2 157 689
- JP-A- H11 178 356
- JP-A- 2010 200 403

## Description

### BACKGROUND OF INVENTION

### 1. Field of the Invention

The present invention relates to a gate driving power supply system and an inverter control circuit which are used for an inverter system having a plurality of power transistors subjected to switching control for supplying electric power for controlling to a gate driving circuit for each of the power transistors. The invention particularly relates to a gate driving power supply system and an inverter control circuit which, in an inverter system formed with power transistors such as insulated gate bipolar transistors (IGBTs) and MOSFETs (Metal Oxide Semiconductor - Field Effect Transistors), supply electric power to the gate driving circuits of the power transistors.

### 2. Background Art

In an inverter system formed of semiconductor switching devices such as power transistors, a gate driving power supply system is used which supplies electric power to the gate driving circuit for the power transistors.

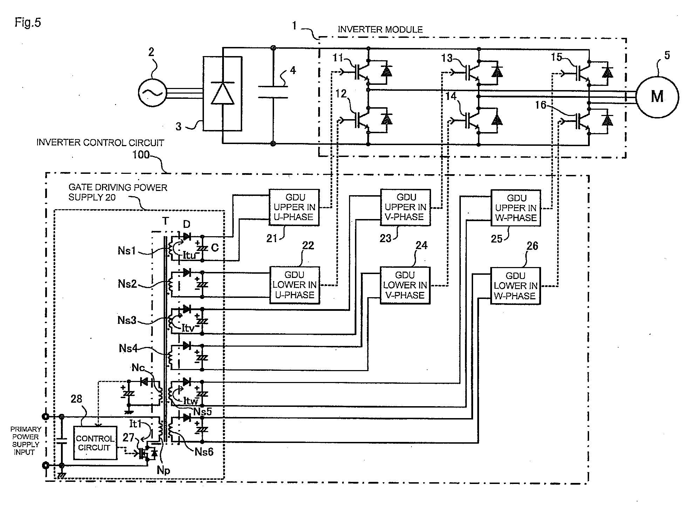

FIGURE 5 is a circuit diagram showing an example of a related inverter system using a gate driving power supply system. The gate driving power supply system is a system to which a power supply system known as a flyback converter system is introduced. The flyback converter system is one of the most commonly used systems for gate driving power supply systems of inverter systems.

In FIG. 5, to an inverter module 1, a power supply is connected in which an output of an AC power supply 2 is converted to a DC output by a main circuit rectifier 3 and a smoothing capacitor 4. Incidentally, the power supply for the inverter module 1 is not limited to this but can be a DC power supply such as a car battery. The inverter module 1 is formed of six power transistors 11 to 16 forming three arms, each with two power transistors, in U-, V- and W-phases of three-phase AC to produce a desired AC output by a controlling input for each of the arms in the U-, V- and W-phases and supplies the produced AC output to an induction motor (M) 5 connected to the inverter module 1 as its load. To the power transistors 11 to 16, an inverter control circuit 100 is connected which is provided with gate driving units (GDU) 21 to 26 controlling the gate voltages of the power transistors 11 to 16, respectively. The gate driving units 21 to 26, by carrying out on-off control of their respective power transistors 11 to 16 in the inverter module 1, are capable of carrying out driving control of the induction motor (M) 5 at a proper speed regardless of electric power variations in the AC power supply 2 and variations in the load thereof.

In the inverter system of such a kind, reference potentials of the gate driving units 21 to 26 which supplies the electric power to the power transistors 11 to 16, respectively, are different from one another. Therefore, for forming a gate driving power supply 20, a method is generally used by which a multiple winding transformer T is provided between the power supply output to each of the gate driving units 21 to 26 and a primary power supply input to the inverter control circuit 100 as shown in FIG. 5 to insulate the power supply output to each of the gate driving units 21 to 26 from the primary power supply input to the inverter control circuit 100. In this method, a current in the primary winding Np of the multiple winding transformer T is subjected to on-off control by a MOSFET 27 and an output voltage detected by an auxiliary winding Nc is fed back to a gate power supply control circuit 28 to control each of outputs of secondary windings Ns1 to Ns6.

When the inverter module 1 is formed as a three-phase inverter, following four kinds of power supplies are provided for the six gate driving units 21 to 26. Namely, a power supply to an upper arm in U-phase, a power supply to an upper arm in V-phase, a power supply to an upper arm in W-phase and a power supply to each of lower arms in their respective U-, V- and W-phases. For forming such a power supply system, in the gate driving power supply 20, four or six power supply outputs insulated one another are required. Namely, with the power supplies to lower arms in their respective phases made in common, four power supply outputs become necessary. While, with the power supply to each of lower arms in their respective phases provided independently for preventing noises from entering through a ground line, six power supply outputs become necessary. The power supply systems each with the lower arms further insulated, however, are often used for inverters with relatively large capacities of tens of kilowatts or more. In FIG. 5, a gate driving power supply 20 is shown which has a configuration with six outputs insulated from one another.

In JP-A-2006-81232, a gate driving system is disclosed in which electric power to driving units for a plurality of power transistors 11 to 16 is supplied from transformers provided independently of one another. The gate driving power supply system is a system in which each transformer simply carries out an AC to AC conversion, which makes it unnecessary to control the operation of each transformer. Therefore, transformers each being independent of one another can be used.

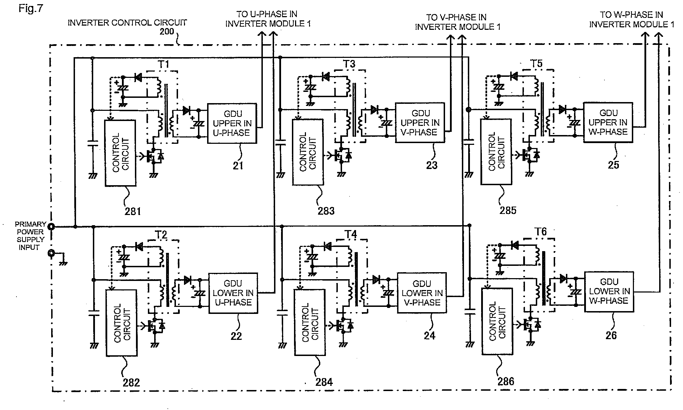

Compared with this, in the case of supplying electric power by the above explained power supply of the flyback converter system shown in FIG. 5, the control of the switching operation of each of the flyback converters was necessary which supply electric power to gate driving circuits 21 to 26. With respect to this, there is an idea of providing a system like that shown in FIG. 5 in which system one auxiliary winding Nc for feedback and the gate power supply control circuit 28 are provided for representing a plurality of flyback converters, to thereby simultaneously control all of the switching operations. As an alternative one, like an inverter control circuit 200 shown in FIG. 7 that will be explained later, a feedback circuit and a control circuit can be provided for each transformer so as to form an individual power supply circuit.

The gate driving power supply 20 shown in FIG. 5, by also insulating the lower arm thereof as was explained in the foregoing, prevents noise currents from entering through the ground line to become a system that prevents the inverter module 1 from malfunctions due to noises. As was disclosed in JP-A-9-135574, for supplying an insulated power supply output to each arm, the multiple winding transformer T shown in FIG. 5 has been previously used.

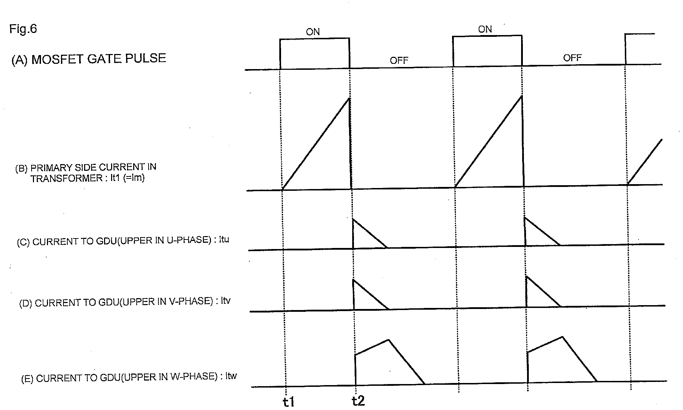

In the next, an explanation will be made with respect to the operation principle of the above explained gate driving power supply 20 on the basis of FIG. 6, a timing chart showing an operation signal in the MOSFET, an operation signal on the primary side of the transformer and an operation signal on the secondary side of the transformer for the upper arm in each of U-, V- and W-phases in the circuit shown in FIG. 5.

Here, for simplifying the explanation, with respect to insulated outputs of the multiple winding transformer T, those of only three upper arms (Itu to Itw) are illustrated.

In FIG. 6, at the time t1, a gate pulse transmitted from the gate power supply control circuit 28 to the MOSFET 27 becomes the gate pulse instructing turning-on. At this time, an exciting current It1 starts to flow in the primary winding Np of the multiple winding transformer T. The exciting current It1 gradually increases from zero, by which excitation energy is stored in an excitation inductor of the transformer T.

Subsequent to this, at the time t2, the gate pulse transmitted to the MOSFET 27 becomes the gate pulse instructing turning-off. At this time, currents Itu, Itv and Itw flow in the secondary windings Ns1, Ns3 and Ns5, respectively, of the multiple winding transformer T in the direction of releasing the energy stored in the multiple winding transformer T.

To each of the secondary windings Ns1 to Ns6 of the multiple winding transformer T, a diode D is connected in series. Thus, an increase in a load connected to each of insulated outputs to lower a charging voltage of a smoothing capacitor C (that is, an output voltage) acts so that a current preferentially flows into a section in a phase (W-phase) with a lowered output voltage. By such an action, output voltages to the gate driving units 21, 23 and 25 are made leveled out. Moreover, with the use of the auxiliary winding Nc, the output voltage is detected, which is fed back to the gate power supply control circuit 28. In this way, by adjusting a duty ratio of the MOSFET 27, the output voltage can be controlled so as to come to have a specified value.

FIGURE 7 is a circuit diagram showing a related inverter control circuit with an individual power supply control circuit provided for each of insulated outputs.

Here, with the inverter module 1 shown in FIG.5 being omitted, only an inverter control circuit 200 is shown. A method is adopted by which individual gate driving units 21 to 26 have their respective primary power supply inputs insulated by independent transformers T1 to T6, respectively. The transformers T1 to T6 are provided with gate power supply control circuits 281 to 286, respectively, each forming an individual power supply control circuit together with a switching device and an auxiliary winding Nc for feedback.

In addition, the inverter control circuit 100 shown in FIG. 5 or the inverter control circuit 200 shown in FIG. 7 is arranged on a single control circuit substrate for the inverter module 1.

Patent Document 3 discloses a main power source supplied to the primary windings of a plurality of insulation transformers. A transistor is connected in series to the primary winding and a control circuit is connected to the base of the transistor. The voltages output by the secondary windings of the transformers via diodes function as power sources.

Patent Document 4 describes a power switching element which is driven according to a drive signal transmitted via a photocoupler by a drive control circuit. A primary side of the photocoupler uses a capacitor as a power source. A control circuit controls supply of power to a transformer in the drive circuit DC by a power-on operation signal for feedback controlling the voltage of the capacitor

Patent Document 1 JP-A-2006-81232
Patent Document 2 JP-A-9-135574
Patent Document 3 JP H11 178356 A
Patent Document 4 JP 2010 200403 A

The multiple winding transformer T explained in the foregoing is, in the inverter control circuit 100 including gate driving units 21 to 26, a part having a larger part size and a heavier weight compared with those of other electronic parts. In particular, as in the circuit shown in FIG. 5, a multiple output power supply formed with one multiple winding transformer T results in uneven disposition of a part with a relatively heavy weight on a control circuit substrate. Thus, the use of such inverter control circuit 100 for a car-mounted inverter caused a problem of degradation in resistance to vibration due to offset of the center of gravity of the system.

Therefore, for improving the resistance to vibration of the inverter, there is an idea of dividing the transformer into six to be disposed at six positions (can be disposed at four positions) as the transformers T1 to T6 in the inverter control circuit 200 shown in FIG. 7 to obtain a power supply outputs individually. At this time, for carrying out output voltage control operations of four or six kinds, each of the transformers T1 to T6 requires its own gate power supply control circuit as shown in FIG. 7, which was a problem of causing an increase in the number of parts to adversely affect the cost and the size of the system.

The invention has been made in view of such points with an object of providing a gate driving power supply system and an inverter control circuit in which a transformer is arranged for an output of each of individual power supply circuits and, along with this, control circuits for their respective power supply circuits are integrated into one to thereby reduce the number of parts.

### SUMMARY OF THE INVENTION

In the invention, for solving the above problem, a gate driving power supply system is provided which is used for an inverter, having a plurality of power transistors subjected to switching control, for supplying control power to a plurality of gate driving units provided for a plurality of the power transistors. The gate driving power supply system includes a plurality of flyback transformers each supplying electric power from a secondary winding thereof to its own gate driving unit, and a gate power supply control circuit for making a plurality of flyback converters, formed of a plurality of the flyback transformers, carry out switching operations with a timing being common thereto. A plurality of the flyback transformers have their respective primary windings being connected to one another by common connection lines.

Moreover, an inverter control circuit of the invention is characterized in that the circuit includes a plurality of gate driving units producing gate driving signals for a plurality of power transistors, a plurality of flyback transformers each supplying electric power from a secondary winding thereof to its own gate driving unit, and a gate power supply control circuit for making a plurality of flyback converters, formed of a plurality of the flyback transformers, carry out switching operations with a timing being common thereto, a plurality of the flyback transformers having their respective primary windings being connected to one another by common connection lines.

According to the gate driving power supply system and the inverter control circuit of the invention, when power is supplied to the control circuit for controlling an inverter module in polyphase formed of a plurality of the power transistors, a plurality of transformers are used which are separated for their respective power transistors. Along with this, the transformers are arranged while being distributed to make it possible to improve resistance to vibration. Furthermore, there is an advantage that the respective control circuits are integrated into one to thereby make it possible to reduce the number of parts.

### BRIEF DESCRIPTION OF THE DRAWINGS

FIG. 1 is a circuit diagram showing a non-claimed comparative example of a gate driving power supply system helpful to understand the invention;
FIG. 2 is a timing chart showing operation signals in a MOSFET and operation signals on the primary and secondary sides of a transformer for an upper arm in each of U-, V- and W-phases in the circuit shown in FIG. 1;
FIG. 3 is a circuit diagram showing a second embodiment, which is the claimed embodiment, of a gate driving power supply system according to the invention;
FIG. 4 is a timing chart showing operation signals in a MOSFET and on the primary and secondary sides of a transformer for an upper arm in each of U-, V- and W-phases in the circuit shown in FIG. 3;
FIG. 5 is a circuit diagram showing an example of a related inverter system using a gate driving power supply system;
FIG. 6 is a timing chart showing an operation signal in a MOSFET, an operation signal on the primary side of a transformer and an operation signal on the secondary side of the transformer for an upper arm in each of U-, V- and W-phases in the circuit shown in FIG. 5; and
FIG. 7 is a circuit diagram showing a related inverter control circuit with an individual power supply control circuit provided for each of insulated outputs.

### DESCRIPTION OF THE PREFERRED EMBODIMENT

In the following, embodiments of the invention will be explained with reference to the attached drawings.

### (First Embodiment)

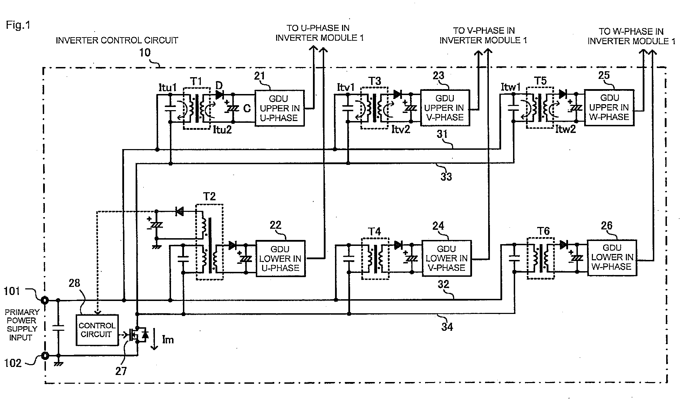

FIGURE 1 is a circuit diagram showing a comparative example of a gate driving power supply system helpful to understand the invention.

An inverter control circuit 10 is provided with six gate driving units (in FIG. 1, denoted as GDUs of upper side and lower side in U-phase, GDUs of upper side and lower side in V-phase and GDUs of upper side and lower side in W-phase) 21 to 26 as circuits for carrying out on-off control of power transistors 11 to 16, respectively, in an inverter module 1 not shown (see FIG. 5). For example, the gate driving units 21 and 22 are units connected to the gate electrodes of the power transistors 11 and 12 controlling the upper and lower arms, respectively, in U-phase of the inverter module 1.

To each of the gate driving units 21 to 26, electric power is supplied through individual transformers T1 to T6, respectively, from power supply terminals 101 and 102. Moreover, one end of the primary winding of each of the transformers T1, T3 and T5 is connected to the power supply terminal 101 by a power supply line 31 and one end of the primary winding of each of the transformers T2, T4 and T6 is connected to the power supply terminal 101 by a power supply line 32. Furthermore, the other end of the primary winding of each of the transformers T1, T3 and T5 is connected to a common connection line 33, which is connected to the drain terminal of a MOSFET 27, and the other end of the primary winding of each of the transformers T2, T4 and T6 is connected to a common connection line 34, which is also connected to the drain terminal of the MOSFET 27. This provides a configuration so that a current in the primary winding of each transformer is controlled. The power supply lines 31 and 32 also serve as connection lines.

Here, for the gate driving unit 21, a diode D and a smoothing capacitor C directly connected to the secondary winding of the transformer T1 are provided as shown in FIG. 1 and the diode voltage is supplied to the gate driving unit 21 as a power supply voltage. Moreover, although only the transformer T2 for the gate driving units 22 that controls a lower arm in U-phase is different from others in that it is provided with an auxiliary winding, all of the transformers T1 to T6 are common in that the transformers T1 to T6 are similarly formed as gate driving power supplies for the gate driving units 21 to 26.

Here, an output voltage detected by the auxiliary winding of the transformer T2 is fed back to a gate power supply control circuit 28 to control a duty ratio for carrying out on-off control of the MOSFET 27. In this way, the value Im of a current flowing in the MOSFET 27 can be controlled, by which an output current flowing in the secondary winding of each of the transformers T1, T3 and T5 through the connection line 33 and an output current flowing in the secondary winding of each of the transformers T2, T4 and T6 through the connection line 34 are controlled to have correct magnitude.

A gate power supply control circuit in the inverter control circuit 10 has configurative characteristics as follows. First, the introduction of a so-called flyback converter system into the power supply control system. This makes it possible to adequately cope with variations in the load of the gate driving power supply system occurring according to the number of times of switching of the power transistors.

Second, no use of the multiple winding transformer in the example of the related system shown in FIG. 5. Namely, power supplies for four outputs insulated from one another or six outputs insulated from one another are made to be given by individually provided transformers. Therefore, a plurality of transformers can be arranged on a control circuit substrate while being distributed to make it possible to correct offset of center of gravity of the system.

Third, reduction in the number of parts with the MOSFET 27 as a switching device and the gate power supply control circuit 28 integrated into one compared with the number of parts in the circuit shown in FIG. 7 as an example of a related system. Therefore, in the transformers T1, T3 and T5 provided in a plurality of number, their respective primary windings are connected to one another by the connection lines 31 and 33 and also in the transformers T2, T4 and T6 provided in a plurality of number, their respective primary windings are connected to one another by the connection lines 32 and 34 which are connected to the connection lines 31 and 33, respectively, by which the actions of the primary windings of the transformers T1 to T6 on their respective secondary windings are made to be common to one another.

Next to this, explanations will be made with respect to the operations of the gate driving units 21 to 26.

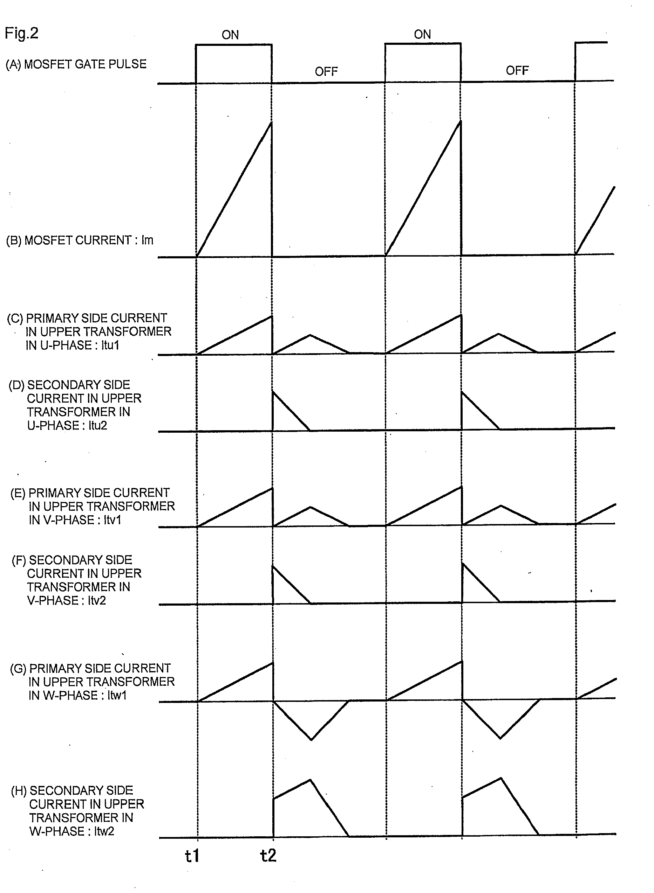

FIGURE 2 is a timing chart showing operation signals in a MOSFET and operation signals on the primary and secondary sides of a transformer for an upper arm in each of U-, V- and W-phases in the circuit shown in FIG. 1. In FIG.2, for simplifying the explanation, only waveforms with respect to the timings of the transformers T1, T3 and T5 corresponding to upper arms in U-, V- and W-phases, respectively, are illustrated.

As is illustrated in (A) in the figure, with a gate pulse to the MOSFET 27 becoming a pulse instructing turning-on at the timing t1, a current Im in the MOSFET 27 illustrated in (B) in the figure begins to flow. At this time, in the primary windings of the transformers T1, T3 and T5, exciting currents Itu1, Itv1 and Itw1 flow, respectively. Each of the currents gradually increases from zero, by which excitation energy is stored in an excitation inductor (component) of each transformer T1, T3 and T5.

Subsequent to this, with the timing becoming t2, the gate pulse transmitted to the MOSFET 27 becomes the gate pulse instructing turning-off. At this time, currents Itu2, Itv2 and Itw2 flow in the secondary windings in the transformers T1, T3 and T5, respectively, in the direction of releasing the energy stored in the excitation inductance component of each of the transformers T1, T3 and T5. To the secondary winding of each of transformers T1, T3 and T5, a diode D is connected in series. Thus, an increase in a load connected to the insulated output of each of the transformers to lower the charging voltage of the smoothing capacitor C acts so that a current preferentially flows into a section in a phase (W-phase) with a lower output voltage.

Namely, when the MOSFET 27 is turned-on, the secondary side voltage of each of the transformers T1, T3 and T5 is determined by the primary side power supply voltage. While, when the MOSFET 27 is turned-off, the primary side voltage of each of the transformers T1, T3 and T5 is determined by the secondary side output voltages of the respective transformers. With the power supply terminal 101 on the high potential side of the primary side power supply voltage, for example, taken as a reference when the MOSFET 27 is turned-off, at a terminal of the primary winding connected to the MOSFET 27, a voltage is generated which is proportional to a sum of (a voltage across the smoothing capacitor C on the secondary side) + (a forward voltage of the diode D). The smoothing capacitor C on the secondary side of each of the transformers T1, T3 and T5 has a voltage across the terminals varied depending on heaviness or lightness of a load (the gate driving units 21, 23 and 25, respectively) . When the load is light, a current supplied from each of the transformers T1, T3 or T5 becomes larger than a current consumed in each of the loads to raise the value of the voltage across the terminals of the smoothing capacitor C. Conversely, when the load is heavy, a current consumed in each of the loads becomes larger than a current supplied from each of the transformers T1, T3 or T5 to lower the value of the voltage across the terminals of each of the capacitors C. This makes the voltage generated on the primary side when the MOSFET 27 is turned-off higher as the load becomes lighter, and lower as the load becomes heavier. Since the primary windings of the transformers T1, T3 and T5 to be connected to the drain terminal of the MOSFET 27 are connected to one another by the connection line 33, a current flows from a primary winding with a higher voltage to a primary winding with a lower voltage, that is, the current flows from a primary winding of a transformer with a lighter load to a primary winding of a transformer with a heavier load.

In the example shown in FIG. 2, since the load of the transformer T5 in W-phase is large, a current flows so that a part of the excitation energy stored in the transformer T1 in U-phase and the transformer T3 in V-phase is released to the secondary winding of the transformer T5 in W-phase. That is, FIG. 2 shows that when the MOSFET 27 is turned-off, on the primary side, currents flow from the transformer T1 in U-phase and the transformer T3 in V-phase with light loads to the transformer T5 in W-phase through the connection line 33. In the transformer 5 in W-phase, an increase in the primary side current Itw1 thereof also increases the secondary side current Itw2 to make it possible to cope with a heavy load. By such a function of the connection line 33, secondary side voltages of the individual transformers T1 to T6 are leveled. Moreover, with an output of any one of the transformers T1 to T6 in any phase, the output in U-phase in the example shown in FIG. 1, made to be fed back to the gate power supply control circuit 28, control is carried out so that the value of an output voltage becomes the specified value by adjusting the duty ratio of the signal for driving the MOSFET 27 on the basis of the fed back output.

As was explained in the foregoing, in the embodiment, the transformers T1 to T6 are arranged while being made to be distributed on a control circuit substrate. Therefore, while improving resistance to vibration of the control circuit, all of the output voltage can be controlled without increasing the number of the control circuits.

### (Second Embodiment)

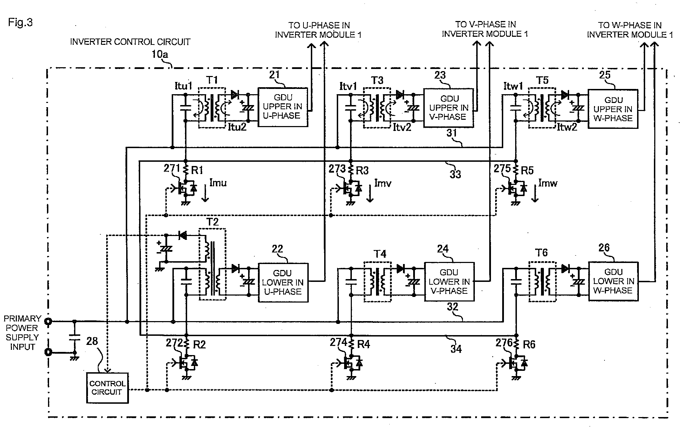

FIGURE 3 is a circuit diagram showing a second embodiment of a gate driving power supply system according to the invention.

In an inverter control circuit 10a shown in FIG. 3, constituents equivalent to those in the first embodiment are denoted by the same reference numerals or signs with explanations thereof omitted. A gate power supply control circuit in the inverter control circuit 10a has configurative characteristics as follows.

First, a plurality of MOSFETs 271 to 276 as switching devices provided in correspondence with their respective gate driving units 21 to 26 compared with one MOSFET 27 as a switching device in the inverter control circuit 10 shown in FIG. 1, and the use of the MOSFETs 271 to 276 while making them connected in parallel to the only one gate power supply control circuit 28. This makes a pulse current, flowing in the MOSFET 27 with a large peak value in the first embodiment, to be divided to flow in each of the MOSFETs 271 to 276.

Second, an arrangement of the MOSFETs 271 to 276 provided close to their respective individual transformers T1 to T6, which are arranged while being made distributed. This reduces kinds of lines routed on the control circuit substrate to only DC signal lines.

In this case, in the MOSFETs 271 to 276 connected in parallel to the gate power supply control circuit 28, series resistors R1 to R6 are connected to the drain terminals of the MOSFETs 271 to 276, respectively, so that no currents flowing therein become unbalanced. Moreover, the primary windings of the transformers T1, T3 and T5 are connected to one another by the connection lines 31 and 33 and also the primary windings of the transformers T2, T4 and T6 are connected to one another by the connection lines 32 and 34 which are connected to the connection lines 31 and 33, respectively, by which the actions of the primary windings of the transformers T1 to T6 on their respective secondary windings are made to be common to one another.

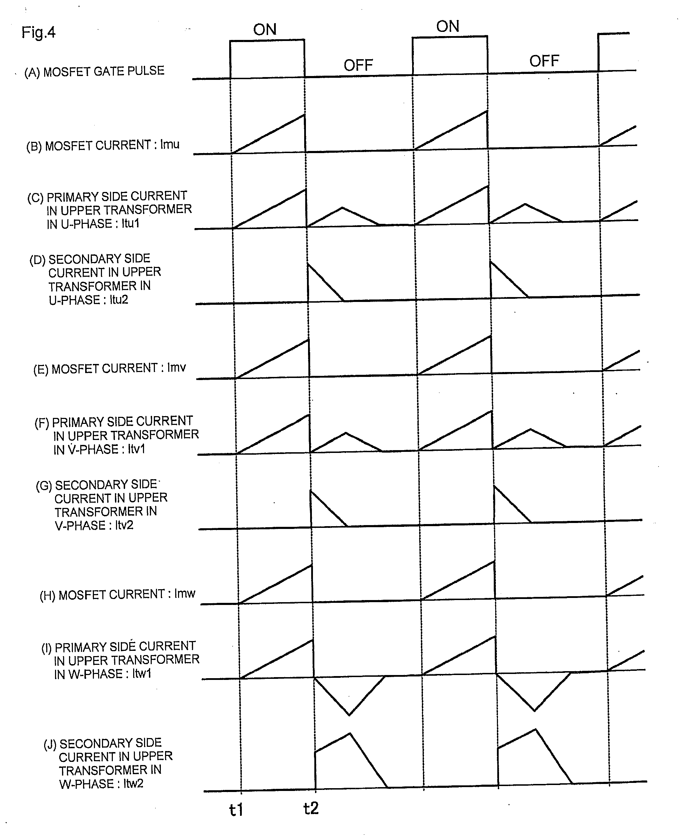

FIGURE 4 is a timing chart showing operation signals in a MOSFET and on the primary and secondary sides of a transformer for an upper arm in each of U-, V- and W-phases in the circuit shown in FIG. 3. Also here, for simplifying the explanation of the operations shown in FIG. 4, only waveforms with respect to the timings of the transformers T1, T3 and T5 corresponding to upper arms in U-, V- and W-phases, respectively, are illustrated.

As is illustrated in (A) in the figure, with a gate pulse to the MOSFET 27 coming to be turned-on at the timing t1, a current Imu in the MOSFET 27 illustrated in (B) in the figure begins to flow. At this time, in the primary windings of the transformers T1, T3 and T5, exciting currents Itu1, Itv1 and Itw1 flow, respectively. Each of the currents gradually increases from zero, by which excitation energy is stored in an excitation inductor of each transformer.

Here, the basic operation is not different from the operation in the case of the first embodiment shown in FIG. 2. However, as waveforms (B), (E) and (H) shown in FIG. 4, currents Imu, Imv and Imw flowing in the MOSFETs 271, 273 and 275, respectively, have their respective peak values reduced with a flow of a pulse current having a large peak value, like the current Im with the waveform (B) shown in FIG. 2, being divided. This can prevent heat generation from being localized. Moreover, the length of the wiring in which a pulse current flows can be shortened to make it possible to reduce noise generation.

In this way, in the gate driving power supply system of the second embodiment, the transformers T1 to T6 are arranged while being made distributed on the control circuit substrate, by which not only can resistance to vibration be improved, but the heat generation can be prevented from locally concentrating by reducing the peak value of a pulse current with a large amplitude. Moreover, on the control circuit substrate, the MOSFETs 271 to 276 are arranged close to the transformers T1 to T6, respectively, arranged while being made distributed. Thus, it becomes unnecessary to route wiring for letting pulse currents flow in the transformers T1 to T6, by which increases in noise currents in the circuit are inhibited with accompanied malfunctions can be certainly prevented.

While the present invention has been particularly shown and described with reference to the preferred embodiments thereof, it will be understood by those skilled in the art that the foregoing and other changes in form and details can be made therein without departing from the scope of the present invention.

Features, components and specific details of the structures of the above-described embodiments may be exchanged or combined to form further embodiments optimized for the respective application. As far as those modifications are readily apparent for an expert skilled in the art they shall be disclosed implicitly by the above description without specifying explicitly every possible combination, for the sake of conciseness of the present description.

## Claims

1. A gate driving power supply system configured to be used for an inverter (1) which has a plurality of power transistors (11-16) subjected to switching control, for supplying control power to a plurality of gate driving units (21-26) provided for a plurality of the power transistors (11-16), the gate driving power supply system comprising:
a plurality of flyback transformers (T1-T6), each supplying electric power from a secondary winding thereof to its own gate driving unit (21-26); and
a gate power supply control circuit (28) for making a plurality of flyback converters, formed of a plurality of the flyback transformers (T1-T6), carry out switching operations with a timing being common thereto,
a plurality of the flyback transformers (T1-T6) having first ends of their respective primary windings connected to one another by common connection lines (31, 32), and having the other ends of their respective primary windings connected to one another by further connection lines (33, 34), **characterized in that**
a switch (271-276) is arranged for each of the plurality of flyback transformers (T1-T6), wherein each switch (271-276) is connected to a common connection line (33, 34) through a resistor (R1-R6);
one of the plurality of flyback transformers (T2) comprises an auxiliary winding for providing a feedback signal to the gate power supply control circuit (28).

2. The gate driving power supply system as claimed in claim 1, wherein a plurality of the flyback transformers (T1-T6) are provided while being made to be distributed on a circuit substrate on which the gate driving units (21-26) are arranged.

3. The gate driving power supply system as claimed in claim 1 or 2, wherein the gate power supply control circuit carries out on-off control of a single switching device being common to a plurality of the flyback transformers (T1-T6), by which switching operations of a plurality of the flyback converters are carried out.

4. The gate driving power supply system as claimed in at least one of claims 1 to 3, wherein a plurality of the switching devices, whose switching operations are controlled by the gate power supply control circuit, are provided for their respective flyback transformers (T1-T6).

5. The gate driving power supply system as claimed in claim 4, wherein a plurality of the switching devices are connected to one another through their respective flyback transformers (T1-T6) and resistor circuits.

6. The gate driving power supply system as claimed in at least one of the preceding claims, wherein each of the plurality of flyback transformers (T1-T6) comprises an input capacitor connected in parallel to a primary winding thereof.

7. An inverter control circuit for controlling an inverter (1) having a plurality of power transistors (11-16) subjected to switching control, the inverter control circuit comprising:
a plurality of gate driving units (21-26) producing gate driving signals for a plurality of power transistors (11-16), and a gate power supply system according to at least one of claims 1 to 6.

## Patentansprüche

1. Stromversorgungssystem für die Gate-Ansteuerung, das dazu konfiguriert ist, für einen Wechselrichter (1) verwendet zu werden, der eine Vielzahl von Leistungstransistoren (11-16) aufweist, die einer Schaltsteuerung ausgesetzt werden, um Steuerstrom einer Vielzahl von Gate-Ansteuereinheiten (21-26) zuzuführen, die für eine Vielzahl der Leistungstransistoren (11-16) vorgesehen sind, wobei das Stromversorgungssystem für die Gate-Ansteuerung umfasst:
eine Vielzahl von Rücklauftransformatoren (T1-T6), die jeweils elektrische Energie aus einer Sekundärwicklung derselben an ihre eigene Gate-Ansteuereinheit (21-26) liefern; und
eine Gate-Stromversorgungssteuerschaltung (28), um zu bewirken, dass eine Vielzahl von Sperrwandlern, die aus einer Vielzahl der Rücklauftransformatoren (T1-T6) gebildet sind, Schaltvorgänge mit einem gemeinsamen Timing ausführen,
eine Vielzahl der Rücklauftransformatoren (T1-T6), die mit ersten Enden ihrer jeweiligen Primärwicklungen durch gemeinsame Verbindungsleitungen (31, 32) miteinander verbunden sind, und die mit den anderen Enden ihrer jeweiligen Primärwicklungen durch weitere Verbindungsleitungen (33, 34) miteinander verbunden sind, **dadurch gekennzeichnet, dass**
ein Schalter (271-276) für jeden der Vielzahl von Rücklauftransformatoren (T1-T6) angeordnet ist, wobei jeder Schalter (271-276) mit einer gemeinsamen Verbindungsleitung (33, 34) über einen Widerstand (R1-R6) verbunden ist;
einer der Vielzahl von Rücklauftransformatoren (T2) eine Hilfswicklung zum Bereitstellen eines Rückkopplungssignals an die Gate-Stromversorgungssteuerschaltung (28) umfasst.

2. Stromversorgungssystem für die Gate-Ansteuerung nach Anspruch 1, wobei eine Vielzahl der Rücklauftransformatoren (T1-T6) vorgesehen ist, um auf einem Schaltungssubstrat verteilt werden, auf dem die Gate-Ansteuereinheiten (21-26) angeordnet sind.

3. Stromversorgungssystem für die Gate-Ansteuerung nach Anspruch 1 oder 2, wobei die Gate-Stromversorgungssteuerschaltung eine Zweipunkt-Steuerung einer einzelnen Schaltvorrichtung durchführt, die einer Vielzahl der Rücklauftransformatoren (T1-T6) gemeinsam ist, durch die Schaltvorgänge einer Vielzahl der Sperrwandler ausgeführt werden.

4. Stromversorgungssystem für die Gate-Ansteuerung nach mindestens einem der Ansprüche 1 bis 3, wobei eine Vielzahl der Schaltvorrichtungen, deren Schaltvorgänge durch die Gate-Stromversorgungssteuerschaltung gesteuert werden, für ihre jeweiligen Rücklauftransformatoren (T1-T6) vorgesehen sind.

5. Stromversorgungssystem für die Gate-Ansteuerung nach Anspruch 4, wobei eine Vielzahl der Schaltvorrichtungen über ihre jeweiligen Rücklauftransformatoren (T1-T6) und Widerstandsschaltungen miteinander verbunden sind.

6. Stromversorgungssystem für die Gate-Ansteuerung nach mindestens einem der vorhergehenden Ansprüche, wobei jeder der Vielzahl von Rücklauftransformatoren (T1-T6) einen Eingangskondensator umfasst, der zu einer Primärwicklung davon parallel geschaltet ist.

7. Wechselrichtersteuerschaltung zum Steuern eines Wechselrichters (1) mit einer Vielzahl von Leistungstransistoren (11-16), die einer Schaltsteuerung ausgesetzt werden, wobei die Wechselrichtersteuerschaltung umfasst:
eine Vielzahl von Gate-Ansteuereinheiten (21-26), die Gate-Ansteuersignale für eine Vielzahl von
Leistungstransistoren (11-16) erzeugen, und ein Gate-Stromversorgungssystem nach mindestens einem der Ansprüche 1 bis 6.

## Revendications

1. Système d'alimentation électrique de pilotage de grille configuré pour être utilisé pour un onduleur (1) qui a une pluralité de transistors de puissance (11-16) soumis à une commande de commutation, pour fournir une puissance de commande à une pluralité d'unités de pilotage de grille (21-26) prévues pour une pluralité des transistors de puissance (11-16), le système d'alimentation électrique de pilotage de grille comprenant :
une pluralité de transformateurs de retour (T1-T6), chacun fournissant une puissance électrique à partir d'un enroulement secondaire de celui-ci à sa propre unité de pilotage de grille (21-26) ; et
un circuit de commande d'alimentation électrique de grille (28) permettant à une pluralité de convertisseurs à transfert indirect, formés d'une pluralité des transformateurs de retour (T1-T6), d'effectuer des opérations de commutation avec une temporisation qui leur est commune,
une pluralité des transformateurs de retour (T1-T6) ayant des premières extrémités de leurs enroulements primaires respectifs reliées entre elles par des lignes de connexion communes (31, 32), et ayant les autres extrémités de leurs enroulements primaires respectifs reliés entre elles par des lignes de connexion supplémentaires (33, 34),
**caractérisé en ce que**
un commutateur (271-276) est agencé pour chacun de la pluralité de transformateurs de retour (T1-T6), chaque commutateur (271-276) étant relié à une ligne de connexion commune (33, 34) par l'intermédiaire d'une résistance (R1-R6) ;
l'un de la pluralité de transformateurs de retour (T2) comprend un enroulement auxiliaire pour fournir un signal de rétroaction au circuit de commande d'alimentation électrique de grille (28).

2. Système d'alimentation électrique de pilotage de grille tel que revendiqué à la revendication 1, dans lequel une pluralité des transformateurs de retour (T1-T6) sont prévus tout en étant conçus pour être répartis sur un substrat de circuit sur lequel les unités de pilotage de grille (21-26) sont disposées.

3. Système d'alimentation électrique de pilotage de grille tel que revendiqué à la revendication 1 ou 2, dans lequel le circuit de commande d'alimentation électrique de grille réalise une commande de fermeture-ouverture d'un dispositif de commutation unique qui est commun à une pluralité des transformateurs de retour (T1-T6), par laquelle des opérations de commutation d'une pluralité des convertisseurs à transfert indirect sont effectuées.

4. Système d'alimentation électrique de pilotage de grille tel que revendiqué à au moins l'une des revendications 1 à 3, dans lequel une pluralité des dispositifs de commutation, dont les opérations de commutation sont commandées par le circuit de commande d'alimentation électrique de grille, sont prévus pour leurs transformateurs de retour (T1-T6) respectifs.

5. Système d'alimentation électrique de pilotage de grille tel que revendiqué à la revendication 4, dans lequel une pluralité des dispositifs de commutation sont reliés entre eux par l'intermédiaire de leurs transformateurs de retour (T1-T6) respectifs et de circuits de résistance.

6. Système d'alimentation électrique de pilotage de grille tel que revendiqué à au moins l'une des revendications précédentes, dans lequel chacun de la pluralité de transformateurs de retour (T1-T6) comprend un condensateur d'entrée relié en parallèle à un enroulement primaire de celui-ci.

7. Circuit de commande d'onduleur pour commander un onduleur (1) ayant une pluralité de transistors de puissance (11-16) soumis à une commande de commutation, le circuit de commande d'onduleur comprenant :
une pluralité d'unités de pilotage de grille (21-26) produisant des signaux de pilotage de grille pour une pluralité de transistors de puissance (11-16), et un système d'alimentation électrique de grille selon au moins l'une des revendications 1 à 6.
